# EUROPÄISCHE PATENTANMELDUNG

(11) **EP 0 592 878 A2**
(43) Veröffentlichungstag der Anmeldung: **20.04.1994**
(21) Anmeldenummer: 93115791.1
(22) Anmeldetag: 30.09.1993
(51) Int. Cl.: G01R 1/073, G01N 21/88, G01R 35/00

(54) **Verfahren und Vorrichtung zur Prüfung von Nadelkarten für die Prüfung von integrierten Schaltkreisen**

(30) Priorität: 15.10.1992 DE 4234856
(71) Anmelder: Ehlermann, Eckhard, Dr., D-80796 München (DE); Rehm, Gisela, 81479 München (DE)
(72) Erfinder: Ehlermann, Eckhard, Dr., D-80796 München (DE); Rehm, Gisela, 81479 München (DE)
(74) Vertreter: Kinne, Reinhard, Dipl.-Ing.

(57) **Zusammenfassung**

Erfindungsgemäß wird ein Verfahren zur Prüfung von Prüfkarten vorgeschlagen, die mit Kontaktnadeln bestückt sindt, die mit den Kontaktflächen integrierter Schaltkreise in Kontakt gebracht werden, um diese zu prüfen, wobei mittels einer Kamera 6 zumindest ein Abdruck A-I einer Kontaktnadel auf einer Kontaktfläche erfaßt wird und ein Bild des Abdrucks A-I einer Auswerteinrichtung 7 zugeführt wird, die einerseits das Bild mit gespeicherten Mustern vergleicht und eine qualitative Bewertung der Nadelabdrücke A-I liefert und andererseits die optimale theoretische Justage aus der Abweichung des Nadelabdrucks von der Sollposition errechnet, wodurch fehlerhaft justierte Kontaktnadeln nach bestimmten objektiven Kriterien erkannt werden und gleich eine entsprechende Korrekturmöglichkeit vorgeschlagen werden kann; wobei die Eichung und Justage der Prüfeinrichtung mittels eines Eichmuster 8 erfolgen kann, das von der Kamera 6 zumindest teilweise erfaßt wird und ein genau definiertes Raster aufweist.

## Beschreibung

Die Erfindung betrifft ein Verfahren und eine Vorrichtung zur Prüfung von Nadelkarten gemäß dem Oberbegriff des Patentanspruchs 1 und 12 bzw. des Patentanspruchs 8 und 17.

Bei der Herstellung von integrierten Schaltkreisen (ICs) wird vor dem Zersägen des Wafers in die Einzelschaltungen bis auf wenige Ausnahmen in der Halbleiterindustrie jedes IC elektrisch gemessen, um diese entsprechend den Qualitätsanforderungen zu sortieren.

Zur Messung der ICs wird der Wafer in eine Testvorrichtung eingesetzt, in der seine Lage exakt definiert ist. Die Kontaktflächen (Pads) heutiger ICs weisen in der Regel eine Fläche von 100 µm x 100 µm auf, wobei für die Zukunft mit einer Verringerung der Kontaktflächen zu rechnen ist. Die Testeinrichtung die den IC elektrisch überprüft muß über eine sogennannte Prüfkarte mit den Kontaktflächen in elektrischen Kontakt gebracht werden, um die elektrische

Verbindung zwischen IC und Testeinrichtung herzustellen.
Die hierzu verwendeten Prüfkarten können eine große Anzahl von Kontaktnadeln (derzeit bis zu 600 Stk.) aufweisen, die mit den Kontaktflächen (Pads) der ICs in Kontakt gebracht werden. Die elektrische Verbindung der Kontaktnadeln mit der Testeinrichtung wird üblicherweise über Federkontakte (Pogo-Pins) oder herkömmliche Stecker hergestellt. Prüfkarten dieser Art sind aus der US-PS 4 599 559 und der DE-OS 41 01 920 bekannt.

Üblicherweise sind die ICs mit einer Schutzschicht versehen, die diese vor Umwelteinflüssen (Feuchtigkeit, Schmutz) schützt. Diese Schutzschicht, auch Passivierung genannt, überlappt den Rand der Kontaktflächen (Pads) um wenige Mikrometer. Diese Schutzschicht darf von der Kontaktnadel nicht verletzt werden, da sonst Feuchtigkeit in den IC einziehen und seine Funktion stören oder zerstören kann.

Derzeit werden die meisten ICs mit Aluminium-Kontaktflächen (AL-Pads) hergestellt. Aluminium bildet mit dem Sauerstoff der Luft sofort eine Oxydhaut, die vor weiterer Oxydation schützt, jedoch elektrisch nicht leitend ist.

Es gibt vereinzelt auch ICs mit Gold-Kontaktflächen (Gold-Bumps) auf denen kein Oxyd gebildet wird: dennoch ist auf diesen Kontaktflächen eine dünne Schicht adsorbierter Moleküle vorhanden. Dabei kann es sich um Wasser- oder Sauerstoffmoleküle handeln; es können aber auch andere Moleküle aus der Umgebungsatmosphäre beispielsweise Schmutzmoleküle adsorbiert werden.

Um eine ausreichende elektrische Verbindung zwischen den Kontaktnadeln und den Kontaktflächen herzustellen, muß mit den Kontaktnadeln die Oxydschicht soweit aufgekratzt werden, daß ein ausreichender Kontakt besteht.

Üblicherweise sind die Kontaktnadeln daher so gestaltet, daß diese beim Aufsetzen der Prüfkarte auf den Wafer, der die ICs beinhaltet, zunächst mit der Spitze auf der Kontaktfläche aufsetzen und dann bei Erhöhung der Flächenpressung zwischen Spitze und Kontaktfläche durch weiteres Anheben des Wafers gegen die Prüfkarte mit der Spitze über die Kontaktfläche kratzen und so die Oxydschicht partiell aufschaben, um einen elektrisch leitenden Kontakt zwischen Spitze und Kontaktfläche herzustellen. Die Kontaktnadeln sind dabei üblicherweise im vorderen Bereich abgewinkelt und federnd gelagert, so daß diese nicht senkrecht mit der Spitze auf der Kontaktfläche aufsetzen, sondern leicht angewinkelt, wodurch das beschriebene "Wegrutschen" der Spitze zur Erzeugung eines Kratzers beim weiteren Anheben des Wafers erzielt wird.

Zum genaueren Aufbau der Prüfkarten wird auf die genannten Schriften verwiesen.
Es ist klar, daß bei den geringen Abmessungen der Kontaktflächen und der geringen Stärke der leitenden Schicht der Kontaktflächen bei der Erzeugung der gewünschten Kratzer mit äußerster Sorgfalt vorgegangen werden muß, um eine Beschädigung der Kontaktflächen zu vermeiden.

Für den Benutzer der Testeinrichtung ist es dabei von Interesse den richtigen Kontaktierhub für das Anheben des Wafers gegen die Prüfkarte zu kennen, der einerseits eine zuverlässige Kontaktherstellung zwischen Kontaktflächen und Kontakt- oder Prüfnadeln gewährleistet und andererseits keine Beschädigung der Kontaktflächen verursacht.
Der richtige Kontaktierhub hängt von verschiedenen Parametern ab. Selbstverständlich spielt die Geometrie der Prüfkarte bzw. der Kontaktnadeln eine große Rolle, da durch diese das Verhalten der Kontaktnadeln bei Erhöhung der Flächenpressung bestimmt wird. Hierzu sind insbesondere die Parameter: Spitzendurchmesser, Nadelform, freie Länge und Neigungswinkel der Nadel zur Kontaktfläche zu nennen.
Während einerseits ein großer Durchmesser der Nadelspitze erwünscht ist, um eine ausreichende Kontaktierfläche zur Verfügung zu haben, verursacht eine größere Nadelspitze bei zu hoher Flächenpressung auch eine größere Beschädigung der Kontaktflächen. Selbstverständlich spielt auch die Empfindlichkeit der Kontaktflächen und der Oxydschichten eine große Rolle, da die Oxydschicht durchbrochen werden soll, die Kontaktflächen jedoch nach Möglichkeit nicht verletzt werden sollen.
Aufgrund der aufgezeigten komplexen Problematik wurde der Kontaktierhub bisher ausschließlich empirisch bestimmt. Ist für einen Prüfkarten-Typ eine passende Einstellung gefunden, wird die Serienprüfung durchgeführt bis zu einer Routinekontrolle, die in vorbestimmten Abständen oder bei Häufung von angezeigten IC-Fehlern bzw. Mängeln durchgeführt wird. Bei einer entsprechenden Kontrolle wird von einer angelernten Kraft, dem Operator, die Prüfkarte und der IC optisch inspiziert; weisen alle Kontaktflächen des ICs gleichmäßige Kratzspuren auf, ist sichergestellt, daß die Kontaktnadeln der Prüfkarte Kontakt mit den Kontaktflächen hatten, wobei nur unzuverlässig zu erkennen ist, ob die Oxydschicht durchbrochen wurde oder nicht. Eine Beschädigung der Kontaktfläche ist dagegen eher zu erkennen.
Aus der optischen Inspektion der Prüfkarte, kann normalerweise nur der Zustand der Nadelspitzen, nicht jedoch deren Justage gut beurteilt werden. Häufiger auftretende Mängel sind: verbogene Nadeln, beschädigte oder verschmutze Nadelspitzen.
Ist die Prüfkarte nicht in ordnungsgemäßen Zustand oder ist diese bzw. die Testanordnung dejustiert, so wird im Normalfall die Ursache der dadurch verursachten Fehleranzeigen nicht gleich erkannt, was dazu führt, daß gute ICs als Ausschuß behandelt werden.
Aus den gemachten Ausführungen dürfte klar geworden sein, daß die bisher bekannten Testverfahren sehr personalaufwendig sind, wobei das Personal besonders geschult sein muß. Darüberhinaus weisen die bekannten Verfahren eine große Anzahl von Fehlerquellen auf, die zu fehlerhaften Testergebnissen führen können.

Aufgabe der Erfindung ist es, ein Verfahren zur Prüfung von integrierten Schaltkreisen zu schaffen, das präzise arbeitet, zuverlässige Prüfergebnisse liefert und sich weitgehend automatisieren läßt. Dabei soll dieses Verfahren den Ausfall der Testeinrichtung des sogenannten Probers beim Prüfkartenwechsel bzw. bei der Untersuchung der Prüfkarte zumindest vermindern und zeitaufwendige Prüfungen der Prüfkarte und Beschädigungen der Karte durch Aus- und Einbau vermeiden.

Weiterhin ermöglicht das Verfahren erstmals objektive Aussagen sowohl über Position und Qualität der Kontaktnadeln, als auch über die Qualität der Kontaktflächen und des verwendeten Probers.
Des weiteren soll eine Vorrichtung zur Durchführung des Verfahrens geschaffen werden.
Die Aufgabe wird durch die Merkmale der Verfahrensansprüche 1 und 11 bzw. der Vorrichtungsansprüche 6 und 16 gelöst.
Erfindungsgemäß wird ein Verfahren geschaffen, bei dem mittels einer Mustererkennungs-Kamera und einer Auswerteinrichtung die Position und Qualität der Kontaktnadeln mittels der Kratzer der Kontaktnadeln auf einem Wafer analysiert werden. Dabei können Wafer mit fertigen ICs verwendet werden, sogenannte strukturierte Wafer, und die Abdrücke (A-I) bzw. Kratzer der Kontaktnadeln auf den Kontaktflächen analysiert werden oder sogenannte unstrukturierte gewissermaßen "unfertige" Wafer verwendet werden, die überhaupt keine Kontaktflächen aufweisen, da auch bei diesen die zur Analyse notwendigen Kratzer auftreten.
Vorteilhafterweise wird diese Analyse von einem Computer durchgeführt, so daß das gesamte Verfahren voll automatisiert durchgeführt werden kann. Wird beispielsweise vom Computer das Fehlen eines Kratzers entdeckt oder ein Kratzer ermittelt, der auf eine gespaltene Nadelspitze hinweist, wird nach der Durchführung der Analyse dem Bedienpersonal eine entsprechende Fehlermeldung gegeben.
Die Analyse der Kratzer kann aber auch zur Justage der Testeinrichtung verwendet werden. Ist beispielsweise die Ebene der Nadelspitzen nicht parallel zu der Ebene der Kontaktflächen ausgerichtet, erscheinen auf einer Seite der Kontaktflächen stärkere Kratzer als auf der gegenüberliegenden Seite.
Auch der Ort der Kratzer auf den Kontaktflächen kann nach einer Analyse korrigiert werden, um im Testbetrieb die Kratzer exakt an einer bestimmten Stelle der Kontaktfläche zu erhalten.

Mit dem neuen Verfahren ist es somit möglich, die Testanordnung sehr schnell einzurichten, zu justieren und den passenden Kontaktierhub der Prüfkarte zu bestimmen; darüber hinaus kann mit dem erfindungsgemäßen Verfahren die Testeinrichtung mit der Prüfkarte kontinuierlich weitgehend automatisch überwacht werden, so daß eventuell auftretende Dejustierungen der Kontaktnadeln oder Schäden an der Prüfkarte oder eine Dejustierung der Testeinrichtung sofort erfaßt werden, ohne daß der eigentliche Testvorgang der ICs unterbrochen werden muß. Eine Demontage von Teilen der Testeinrichtung oder der Prüfkarte ist nicht erforderlich.
Des weiteren erlaubt das erfindungsgemäße Verfahren umfangreiche Rückschlüsse auf die Qualität der Kontaktflächen und der Qualität der Kontaktnadeln.
Das Verfahren kann während des Testbetriebs ausgeführt werden, da lediglich sichergestellt sein muß, daß die zur Untersuchung der Kratzer bestimmte Kamera die Kratzspuren der Prüfnadeln einsehen kann. Die Abbildung der Kratzer kann dann während der Prüfvorgang weiterläuft automatisch vom Computer analysiert und bei Abweichung von dem Soll-Bild der Kratzer ein Alarmsignal gegeben oder der Prüfablauf automatisch gestoppt werden. Dabei kann vom Computer, wie bereits erwähnt, auch automatisch eine Analyse der Kratzer durchgeführt werden. Dabei können zur Analyse der Kratzspuren der Umfang, die Fläche , der Schwerpunkt, die Länge, Breite, der Anfang und das Ende einer Kratzspur vermessen werden sowie die Grauwertverteilung der Nadelabdrücke erfaßt werden. Eine differenzierte Grauwertverteilung ergibt sich aufgrund sogenannter Rüttelmarken im Abdruck, die Sprünge der Nadel beim Aufsetzen zeigen und durch mechanische Vibration oder Inhomogenitäten des Padmaterials verursacht werden.
Diese Messungen können auch zur Justage der Prüfkarte relativ zu den Kontaktflächen ausgewertet werden. Da die Koordinaten der Kontaktflächen bekannt sind, können diese mit den Koordinaten der Kratzer verglichen werden. Aus diesem Vergleich ergibt sich beispielsweise, daß die Position der Prüfkarte mittels einer Translation und Rotation geändert werden muß, um die Kratzer an den gewünschten Stellen der Kontaktflächen zu erhalten. Rechnerisch läßt sich diese Korrektur durchführen indem die ortsabhängigen Daten in Abstände zu den Mitten der Kontaktflächen umgerechnet werden und die Summe der Abstandsquadrate mittels linearer Regression zu einem Minimum gemacht werden, woraus sich die optimale Positionierung der Prüfkarte zu den Kontaktflächen ergibt.
Aus dem Umfang der Kratzer, deren Fläche und Schwerpunkt sind Rückschlüsse auf die Qualität der Nadelspitzen möglich.

Das beschriebene Verfahren weist daher eine Reihe von Vorteilen auf. Besonders hervorzuheben ist, daß die Prüfkarte zur Überprüfung nicht aus dem Prober entnommen werden muß, da die Überprüfung der Prüfkarte anhand der durch diese erzeugten Kratzer auf dem Wafer erfolgt. Dadurch wird nicht nur Justieraufwand beim Wiedereinsetzten der Karte gespart, sondern auch die Ausfallszeit des Probers vermindert. Desweiteren wird die Prüfkarte geschont, da eine zusätzliche Auslenkung der Kontaktnadeln nur zu deren Überprüfung nicht erforderlich ist, und es beim Montieren und Demontieren auch leicht zu Beschädigungen der Prüfkarte kommt. Werden Fehljustierungen erkannt, kann die Prüfkarte bzw. können einzelne Kontaktnadeln im Prober nachjustiert werden.

Durch das beschriebene Verfahren ist es möglich, die Tests am Prober unter sehr hohen Temperaturen - Heißmessungen bis 500 °C - durchzuführen und über die Kratzeranalyse das Verhalten der Prüfkarte und die erzeugten Kratzer bei diesen hohen Temperaturen zu analysieren.

Mittels des beschriebenen Verfahrens zur Kratzer-Analyse können auch Aussagen über die Qualität der Kontaktflächen der ICs verschiedener Hersteller (Schichtaufbau und Härte) mit ihren statistischen Schwankungen von Charge zu Charge gemacht und gleich protokolliert werden. Des weiteren können die mechanischen Wirkungen einer Prüfkartenhalterung und des Probers auf die Kontaktqualität bestimmt werden, indem die Kratzer, die mit einer bestimmten Prüfkarte aber unterschiedlichen Prüfkartenhalterungen und/oder Probern gemacht worden sind, verglichen werden.

Zur Verdeutlichung der Analysemöglichkeiten wird auf die Beschreibung des Ausführungsbeispiels verwiesen, in der auch exemplarisch einige typische Kratzspuren mit Darstellungen beschrieben werden.

Wird mit dem beschriebenen Verfahren eine Abweichung der Kratzer vom vorbestimmten Ort festgestellt, kann mit der beschriebenen Analyse exakt errechnet werden, um welche Strecke die Prüfkarte verschoben bzw. gedreht werden muß. Es kann jedoch auch festgestellt werden, daß lediglich eine oder mehrere einzelne Kontaktnadeln dejustiert sind, wobei durch das beschriebene Verfahren errechnet werden kann, um welchen Betrag und welche Richtung (x,y,z) nachjustiert werden muß. In bestimmten Fällen kann auch festgestellt werden, daß ein Austausch von einzelnen Kontaktnadeln erforderlich ist.

Die zur Analyse der Kratzer verwendeten Arbeitstische weisen jedoch bezüglich der Verstellwege nur eine bestimmte Präzison auf, die oft für eine exakte Positionierung mit einem Steuervorgang nicht ausreicht. Eine genaue Vermessung einer beliebigen Struktur ist daher nur nach einer Eichung des Arbeitstisches möglich, mittels der die Nichtlinearität des Antriebes, die Taumelbewegung quer zur Führung und der Winkelfehler der Führungen zueinander kompensiert werden. Wobei vorteilhaft nicht am Ort der Verursachung kompensiert wird, was beispielsweise bei den Führungen gar nicht ohne weiteres möglich ist, sondern am Ort der Wirkung, was bedeutet, daß die Fehler bzw. Abweichungen des Systems bei der Auswertung berücksichtigt werden.
Erfindungsgemäß wird daher ein Eichverfahren sowie eine Vorrichtung zu dessen Durchführung geschaffen, das es ermöglicht den Arbeitstisch bzw. die Positioniereinrichtung mit einem Steuervorgang exakt zu positionieren.

Zur Durchführung des Verfahrens wird ein Eichmuster auf den Arbeitstisch aufgelegt, das ein bestimmtes Muster und Indexmarkierungen enthält. Das Muster besteht beispielsweise aus parallelen Liniengruppen die exakt einen bestimmten Abstand beispielsweise von 10 µm aufweisen. Wird dieses Muster mittels des verfahrbaren Arbeitstisches unter dem Kamerasehfeld bewegt, kann der tatsächliche Verfahrweg mit dem eingegebenen Verfahrweg verglichen werden, und so eine Eichung des Arbeitstisches vorgenommen werden.
Über die Indexmarkierungen kann der Computer, der die Auswertung des Kamerabildes vornimmt immer feststellen an welcher Position sich der Arbeitstisch befindet. Mittels assymetrischer Markierungen kann von dem System auch seitenverkehrtes Auflegen des Eichmusters erfaßt werden.
Um eine sehr hohe Positionierungsgenauigkeit zu ereichen muß das gesamte optische System kalibriert werden. Dabei ist insbesondere auf eine Kalibrierung von Abbildungsmaßstab, Verzeichnung und Orthogonalität zu achten. Auch diese Kalibrierung kann mit der Verwendung des beschriebenen Eichmusters erfolgen. Hierzu sind sowohl in X- als auch in Y-Richtung parallele Linien vorgesehen, die einen exakten Abstand zu einander aufweisen.
Die Erfindung wird folgend anhand eines Ausführungsbeislpiels näher erläutert.

**Fig. 1** zeigt den schematischen Aufbau einer Analysestation zur Durchführung des erfindungsgemäßen Verfahrens.

**Fig. 2** zeigt von Kontaktnadeln erzeugte Kratzspuren.

**Fig. 3** zeigt ein Eichmuster zur Eichung der Testeinrichtung.

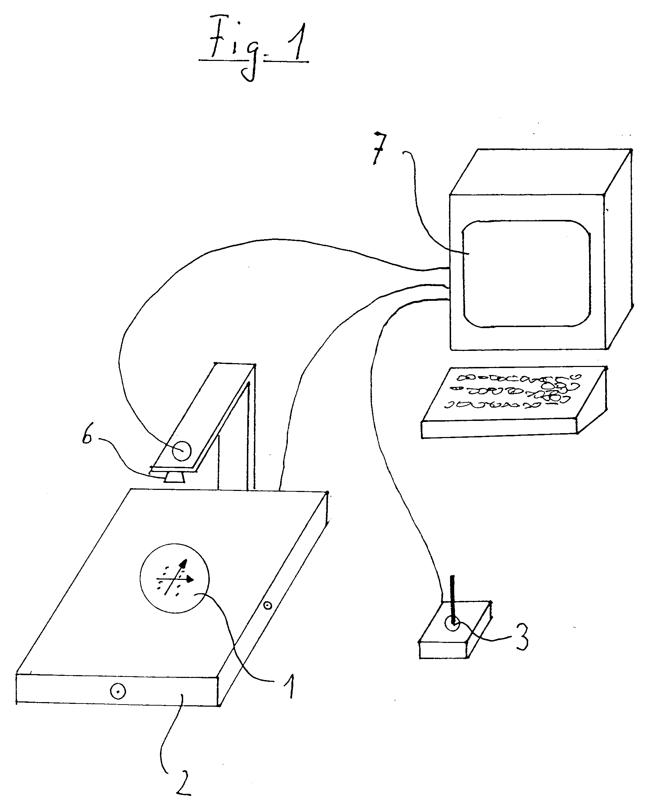

Figur 1 zeigt schematisch den Aufbau einer Analysestation zur Prüfung von Prüfkarten. Nachdem der Wafer 1 in einem herkömmlichen Prober, wie er beispielsweise in der Fachzeitschrift "Solid State Technology, Ausgabe 1/91, Seite 16 oder der Fachzeitschrift "Elektronik Produktion und Prüftechnik, Ausgabe 5/92, Seite 77" gezeigt ist, mit einer Prüfkarte in Kontakt gebracht wurde und entsprechende Kratzspuren aufweist, wird der Wafer 1 auf einem in X- und Y-Richtung verfahrbaren Arbeitstisch 2 positioniert. Oberhalb des Wafers ist eine Kamera 6 vorgesehen, die die Kratzspuren auf dem Wafer einsehen kann. Mittels der Rechnersteuerung, die über die Auswerteinrichtung in diesem Fall ein Personal-Computer 7 erfolgt wird der Arbeitstisch 2 so verfahren, daß die Kamera 6 eine Sollposition für einen Kratzer erfassen kann, die Kamera 6 erfaßt die tatsächlichen Kratzspuren zur optischen Vermessung, deren Koordinaten von dem Computer 7 ausgewertet werden. Der gesamte Wafer 1 kann über eine entsprechende Steuerung des Arbeitstisches 2 durch den Computer 7 abgetastet werden; der Arbeitstisch kann jedoch auch vom Bediener manuell über einen Joy-Stick 3 gesteuert werden.
Die Analyse der Kratzspuren könnte auch "On-Line" auf dem Prober durch die Prüfkarte hindurch erfolgen, indem die Kamera beispielsweise durch ein Fenster in der Prüfkarte den Wafer einsehen kann. Ein solches "On-Line"-Verfahren hat jedoch den Nachteil, daß der Testbetrieb am Prober verzögert wird, was angesichts der hohen Beschaffungskosten des Probers und des erforderlichen Testers in Höhe von mehreren Millionen DM wirtschaftlich in den meisten Fällen nicht sinnvoll ist.
Die separate Prüfkarten-Analysestation hat den Vorteil der Unabhängigkeit vom laufenden Proberbetrieb. Die Prüfkarten-Analysestation kann in der Prüfkartenfertigung und Wartung zur ständigen Protokollierung der Prüfkarten sowohl beim Hersteller als auch beim Anwender eingesetzt werden. Aus der Änderung spezieller Meßwerte (z.B. Spitzendurchmesser) kann auf die verbleibende Nutzungsdauer der Karte geschlossen werden und rechtzeitig Ersatz beschafft werden.

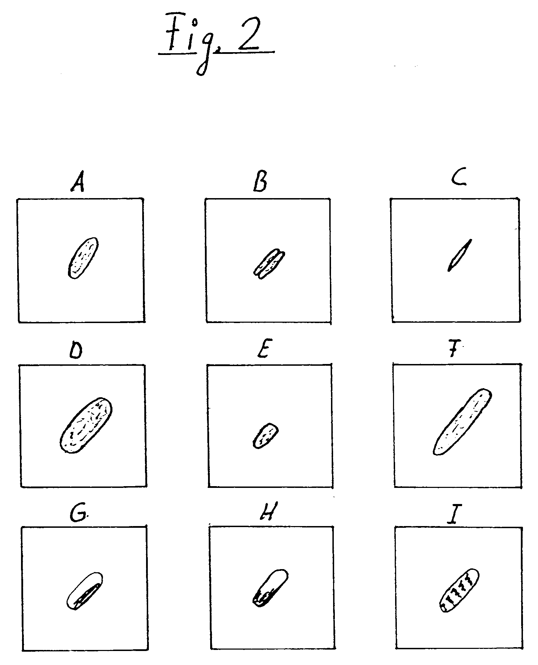

Figur 2 zeigt ein Eichmuster 8 mit dessen Hilfe die Eichung des Arbeitstisches 2 vorgenommen wird. Des weiteren wird mit dem Eichmuster 8 das gesamte optische System kalibriert; hierbei wird besonders auf Abbildungsmaßstab, Verzeichnung und Orthogonalität geachtet. Das Eichmuster 8 ist mit einem Raster versehen, das sowohl parallele Linien in X- als auch in Y-Richtung enthält. Die Linien haben einen exakten Abstand von 10 µm und eine Länge von 50 µm, so daß der vom Arbeitstisch ausgeführte Verfahrweg leicht exakt vermessen und geeicht werden kann; auch der Abbildungsmaßstab des Systems kann über den exakt definierten Linienabstand kalibriert werden. Verzeichnung und Orthogonalität können über die Parallelität der Linien beurteilt werden.
Das Raster weist unsymetrische Markierungen 9 auf, die innerhalb eines Feldes von 1 x 1 mm die Lage des Feldes im 100 x 100 mm Eichfeld angeben. Mittels der Unsymetrie der Markierungen 9 ist es der Auswerteinrichtung 7 möglich, verdrehtes oder seitenverkehrtes Auflegen des Eichmusters 8 zu erkennen.
Die bei diesem Ausführungsbeispiel verwendete Kamera hat ein Sehfeld von 300 µm x 300 µm, wohingegen der Arbeitstisch einen Verfahrweg von 100 mm x 100 mm aufweist. Mittels der zu dem Linienmuster versetzten Indexmarken 10 und der unsymetrischen Markierungen 9 kann die Auswerteinrichtung 7 immer feststellen, an welcher Position sich der Arbeitstisch 2 befindet, ohne daß von einem Endpunkt ausgegangen werden muß.

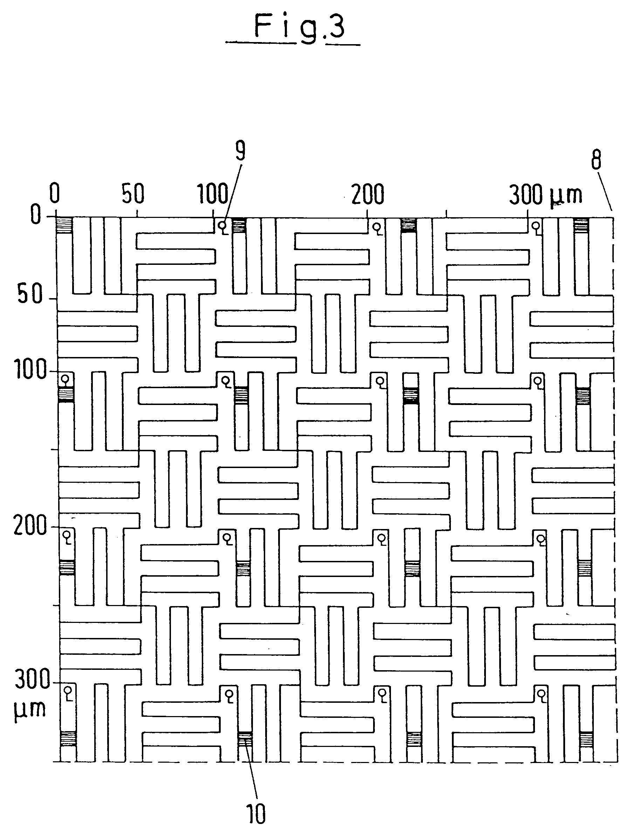

Figur 3 zeigt exemplarisch einige charakteristische von Kontaktnadeln erzeugte Kratzspuren. Bild A zeigt einen guten Nadelabdruck bzw. Kratzspur, der auf eine mängelfreie Kontaktiereinrichtung und eine gute Justage der Prüfkarte schließen läßt.
Beim Aufsetzen der Kontaktnadeln wird mit wachsender Flächenpressung während des Kratzvorgangs ein immer tieferer und breiterer Kratzer erzeugt. Gegen Ende des Kratzers schwimmt die Kontaktnadel auf der zusammengeschobenen Oxydhaut auf, wodurch die Kratzspur gegen Ende sich wieder verjüngt. Eine zusätzliche Verjüngung von Kratzeranfang und Kratzerende wird durch die üblicherweise im Querschnitt kreisförmige Nadelspitze verursacht.

Bild B zeigt einen Abdruck der aus zwei nebeneinander liegenden Ellipsen besteht. Dieser Abdruck wird durch eine gespaltene Kontaktnadel erzeugt. Ein gespaltene Kontaktnadel kann zwar noch einen zufriedenstellenden elektrischen Kontakt zu den Kontaktflächen herstellen; Beschädigungen der Kontaktflächen durch die gebrochene Nadelspitze sind jedoch kaum zu vermeiden.

Bild C zeigt die Kratzspur einer zu dünnen Nadelspitze. Es kann sich hierbei um eine Kontaktnadel handeln, die außerhalb der Toleranz gefertigt wurde; es ist jedoch auch möglich, daß ein Teil der Nadelspitze abgebrochen ist. Die Auswirkungen entsprechen weitgehend denen einer gespaltenen Nadelspitze.
Im Gegensatz dazu zeigt Bild D eine zu dicke Nadelspitze. Als Ursache kommen Fertigungsfehler oder Verschmutzung der Spitze in Frage. Je dicker die Nadelspitze desto geringer ist bei einem vorgegebenen Kontaktierhub die auf der Kontaktfläche erzeugte Flächenpressung. Mit zunehmender Dicke der Spitze wird es daher immer unwahrscheinlicher, daß die Spitze die isolierende Oxydschicht der Kontaktfläche in ausreichendem Maße durchdringt.

Bild E zeigt einen zu kurzen Kratzer, Bild F einen zu langen Kratzer. Die Kratzerlänge hängt im wesentlichen vom Kontaktierhub gegen die Prüfkarte 3 ab. Zeigen alle Nadelabdrücke zu lange Kratzer, ist der Kontaktierhub zu groß. Und entsprechend bei zu kurzen Kratzern zu klein. Weisen jedoch die Nadelabdrücke der Kontaktnadeln einer Seite zu lange Kratzer auf, und die Nadelabdrücke der Kontaktnadeln der gegenüberliegenden Seite zu kurze Kratzer auf, so ist die Ebene der Nadelspitzen nicht parallel zur Ebene der Kontaktfläche. Ursache hierfür kann eine dejustierte verkippte Prüfkarte sein aber auch eine Prüfkarte, die nicht die notwendige Planarität aufweist und in sich verworfen ist. Verwerfungen der Prüfkarte können natürlich zu willkürlichen Anordnungen von zu langen und zu kurzen Kratzern führen.

Bild G zeigt den Nadelabdruck einer beschädigten Spitze einer Kontaktnadel. Der abgebrochene Bereich der Nadelspitze verursacht kaum Kratzspuren, wohingegen der übriggebliebene scharfkantige Teil der Spitze starke Spuren auf der Kontaktfläche hinterläßt und diese beschädigt.
Eine Kontaktnadel kann auch aufgrund fehlerhafter Fertigung eine zu scharfkantige Spitze aufweisen, die Beschädigungen der Kontaktfläche durch Graben der Spitze im Material der Kontaktfläche verursacht. Einen entsprechenden Nadelabdruck zeigt Bild H.

Bild I zeigt einen Nadelabdruck einer Kontaktnadel, die nicht mit dem Material der Kontaktfläche harmoniert. Die Nadel gräbt sich in das Material der Kontaktfläche ein und rutscht anschließend eine Stück über die Oxydschicht der Kontaktfläche, um sich dann wieder einzugraben. Ursache hierfür ist eine mangelhafte Abstimmung von Kontaktnadel und Kontaktfläche. Bei idealer Abstimmung tritt zwischen Kontaktnadel und Kontaktfläche eine Flächenpressung auf, die einerseits ein Rutschen der Nadel über die Oberfläche der Kontaktfläche verhindert und auf der ein gleichmäßiges Durchdringen der Oxydschicht gewährleistet und andererseits eine solche Bewegung der Nadelspitze erlaubt, daß es nicht zu zu tiefen Kratzern und damit Beschädigungen der Kontaktflächen kommt.
Das Reibungsverhalten ist im wesentlichen vom Material der Nadelspitze und der Kontaktflächen sowie von der Geometrie der Nadelspitze und der Oberflächenstruktur der Kontaktfläche abhängig.
Über die Kamera 6 werden die Abbildungen der Nadelabdrücke der Auswerteinrichtung 7 übermittelt, die diese mit gespeicherten typischen Nadelabdrücken vergleicht. Wird beispielsweise ein Nadelabdruck erkannt, der auf eine gespaltene Nadelspitze hinweist, so wird nach der Analyse dem Operator eine entsprechende Information gegeben. Das Ergebnis der Vermessung kann bezüglich aller gemessener Parameter der Kratzer (Umfang, Fläche, Länge, Breite, Schwerpunkt, Grauwertverteilung, Anfang und Ende des Kratzers) ausgegeben werden als Mittelwert, Standardabweichung, Maximalwert, Minimalwert (x, δ, xₘₐₓ , xₘᵢₙ). Dabei können alle Kratzer, deren Meßwerte außerhalb eines vorgegebenen Toleranzbereichs liegen mitsamt den Meßwerten der entsprechenden Parameter und den Nummern der Kontaktnadeln, die die Kratzer erzeugt haben, ausgegeben werden.
Mittels des beschriebenen Verfahrens ist es möglich alle Testeinrichtungen, die das Verfahren benutzen über einen Vergleich der Abddrücke der Kontaktnadeln relativ zueinander zu eichen. So kann zum Beispiel die Bewertung der Graustufenverteilung verschiedener Analyseeinrichtungen aneinander angepaßt werden, um einen einheitlichen Bewertungsmaßstab zu erhalten.

## Patentansprüche

1. Verfahren zur Prüfung von Prüfkarten, die mit Kontaktnadeln bestückt sind, die mit den Kontaktflächen der integrierten Schaltkreise in Kontakt gebracht werden, **dadurch gekennzeichnet, daß** mittels einer Kamera (6) zumindest ein Abdruck (A-I) einer Kontaktnadel auf einem Wafer (1) erfaßt wird und ein Bild des Abdrucks (A-I) der Auswerteinrichtung (7) zugeführt wird.

2. Verfahren nach Anspruch 1, **dadurch gekennzeichnet, daß** die Abdrücke (A-I) aller Kontaktnadeln der Prüfkarte erfaßt werden.

3. Verfahren nach Anspruch 1 oder 2, **dadurch gekennzeichnet, daß** strukturierte oder unstrukturierte Wafer (1) verwendet werden.

4. Verfahren nach einem der Ansprüche 1 bis 3, **dadurch gekennzeichnet, daß** die Auswerteinrichtung (7) die Abdrücke (A-I) der Kontaktnadeln bezüglich zumindest einem der Parameter Fläche, Schwerpunkt, Länge, Breite, Umfang, Position, Anfang, Ende und Grauwertverteilung vermißt.

5. Verfahren nach Anspruch 4, **dadurch gekennzeichnet, daß** die Position der Abdrücke (A-I) mittels einer Analyse der Auswerteinrichtung (7) auf eine Sollposition korrigiert wird.

6. Verfahren nach einem der Ansprüche 1 bis 5, **dadurch gekennzeichnet, daß** die Auswerteinrichtung (7) anhand des Abdrucks einer Kontaktnadel eine Fehljustierung der Kontaktnadel erkennt.

7. Verfahren nach einem der Ansprüche 1 bis 6, **dadurch gekennzeichnet, daß** die Auswerteinrichtung (7) die Abdrücke (A-I) der Kontaktnadeln mit gespeicherten Mustern vergleicht.

8. Vorrichtung zur Durchführung des Verfahrens nach einem der Ansprüche 1 bis 7, **gekennzeichnet durch** eine Kamera (6), die zumindest einen Abdruck (A-I) einer Kontaktnadel erfassen kann.

9. Vorrichtung nach Anspruch 8, **gekennzeichnet durch** eine Auswerteinrichtung (7), die mit der Kamera (6) verbunden ist und das Bild des Abdrucks (A-I) der Kontaktnadel auswertet.

10. Vorrichtung nach Anspruch 9, **dadurch gekennzeichnet, daß** die Auswerteinrichtung (7) die Abdrücke (A-I) der Kontaktnadeln bezüglich zumindest einem der Parameter Fläche, Schwerpunkt, Länge, Breite, Umfang, Position, Anfang, Ende und Grauwertverteilung vermißt.

11. Vorrichtung nach Anspruch 9, **dadurch gekennzeichnet, daß** die Auswerteinrichtung (7) das Bild mit gespeicherten Mustern vergleicht.

12. Verfahren zur Prüfung von Prüfkarten, die mit Kontaktnadeln bestückt sind, die mit den Kontaktflächen der integrierten Schaltkreise in Kontakt gebracht werden, **dadurch gekennzeichnet, daß** vor dem eigentlichen Prüfvorgang der Abdrücke (A-I) der Kontaktnadeln ein Eichmuster (8) mittels einer Kamera (6) zumindest teilweise erfaßt wird und ein Bild des Eichmusters (8) einer Auswerteinrichtung (7) zugeführt wird.

13. Verfahren nach Anspruch 18, **dadurch gekennzeichnet, daß** die Auswerteinrichtung (7) eine Auswertung des Bildes des Eichmusters (8) bezüglich Abbildungsmaßstab und/oder Verzeichnung und/oder Orthogonalität vornimmt.

14. Verfahren nach Anspruch 13, **dadurch gekennzeichnet, daß** aufgrund der Auswertung des Eichmusters (8) eine Kalibrierung des optischen Systems der Prüfeinrichtung erfolgt.

15. Verfahren nach einem der Ansprüche 12 bis 14, **dadurch gekennzeichnet, daß** mittels der Auswertung zumindest zweier Bilder des Eichmusters (8) die Positioniergenauigkeit des den Wafer (1) aufnehmenden Arbeitstischs (2) erfaßt wird.

16. Verfahren nach Anspruch 15, **dadurch gekennzeichnet, daß** aufgrund der Auswertung und der Erfassung der Positionierungsgenauigkeit eine Eichung des Positionierungssystems erfolgt.

17. Eichmuster zur Durchführung des Verfahrens nach einem der Ansprüche 12 bis 16, **gekennzeichnet durch** parallele Linien in X- und Y-Richtung, die einen exakt definierten Abstand aufweisen.

18. Eichmuster nach Anspruch 17, **dadurch gekennzeichnet, daß** die Linien in einem bestimmten Linienmuster angeordnet sind.

19. Eichmuster nach Anspruch 18, **gekennzeichnet durch** relativ zu den Linienmuster versetzte Indexmarkierungen (10).

20. Eichmuster nach einem der Ansprüche 17 bis 19, **gekennzeichnet durch** asymetrische Markierungen (9), die einen exakt definierten Abstand aufweisen.
